# EUROPEAN PATENT APPLICATION

(11) **EP 4 818 844 A1**
(43) Date of publication of application: **07.10.2026**
(21) Application number: 24897471.9
(22) Date of filing: 22.11.2024
(51) Int. Cl.: G05D 3/00, G05B 19/18, G05B 23/02, H01L 21/68

(54) **DATA PROCESSING DEVICE, DATA PROCESSING METHOD, AND STORAGE MEDIUM**

(30) Priority: 27.11.2023 JP 2023200161
(71) Applicant: Sumitomo Heavy Industries, Ltd., Tokyo 141-6025 (JP)
(72) Inventor: TAKAHARA, Daichi, Yokosuka-shi Kanagawa 237-8555 (JP); HAMADA, Shinya, Yokosuka-shi Kanagawa 237-8555 (JP)
(74) Representative: Louis Pöhlau Lohrentz
(86) International application number: PCT/JP2024/041487
(87) International publication number: WO 2025/115785

(57) **Abstract**

A data processing device 4 includes, in a drive device 5 that drives a stage 110 in a movable surface MP of two or more dimensions, a position-dependent data collection unit 41 that collects position-dependent data related to the stage 110 at a plurality of positions of the stage 110 in the movable surface MP, and a distribution data generation unit 42 that generates distribution data of the position-dependent data over at least a part of the movable surface MP. The position-dependent data collection unit 41 collects the position-dependent data when the stage 110 stops at the plurality of positions in the movable surface MP. The position-dependent data is a position deviation, when the stage 110 stops at a plurality of target positions ST in the movable surface MP, between an actual stop position and the target position ST.

## Description

### Technical Field

The present disclosure relates to a data processing device and the like in a drive device.

### Background Art

PTL 1 discloses a technique for diagnosing an abnormality occurring in a drive mechanism by causing a movable portion of a diagnosis target device to repeatedly perform a predetermined initial operation. In each initial operation, a mover is reciprocated from a predetermined initial position, and a deviation between the initial position and a return position is recorded over time as abnormality diagnosis data.

### Citation List

### Patent Literature

[PTL 1] Japanese Unexamined Patent Publication No. 2005-284929

### Summary of Invention

### Technical Problem

In a drive device that drives a movable portion or a driven object as in PTL 1, there is a possibility that an abnormality may occur at a specific position in a movable region of the driven object. In the technique of PTL 1 for diagnosing an abnormality based on a reciprocating operation with a predetermined initial position, there is a possibility that the presence or absence of the abnormality can be determined, but it is difficult to identify the occurrence position of the abnormality.

The present disclosure has been made in view of such circumstances, and an object of the present disclosure is to provide a data processing device and the like capable of making a difference according to a position in a movable region of a driven object apparent.

### Solution to Problem

In order to solve the above-described problem, a data processing device according to an aspect of the present disclosure is a data processing device including, in a drive device that drives a driven object in a movable region of two or more dimensions, a position-dependent data collection unit that collects position-dependent data related to the driven object at a plurality of positions of the driven object in the movable region, and a distribution data generation unit that generates distribution data of the position-dependent data over at least a part of the movable region.

According to the present aspect, since the distribution data of the position-dependent data is generated based on the position-dependent data collected at the plurality of positions in the movable region of the driven object, a difference according to the position of the driven object is made apparent.

Another aspect of the present disclosure is a data processing method. The method executes, in a drive device that drives a driven object in a movable region of two or more dimensions, collecting position-dependent data related to the driven object at a plurality of positions of the driven object in the movable region, and generating distribution data of the position-dependent data over at least a part of the movable region.

Still another aspect of the present disclosure is a storage medium. The storage medium stores a data processing program causing a computer to execute, in a drive device that drives a driven object in a movable region of two or more dimensions, collecting position-dependent data related to the driven object at a plurality of positions of the driven object in the movable region, and generating distribution data of the position-dependent data over at least a part of the movable region.

Any combination of the above components and expression thereof converted into a method, a device, a system, a recording medium, a computer program, and the like are also included in the present disclosure.

### Advantageous Effects of Invention

According to the present disclosure, a difference according to a position in a movable region of a driven object can be made apparent.

### Brief Description of Drawings

FIG. 1 is a perspective view of a stage apparatus to which a fluid actuator is applied.
FIG. 2 is a schematic cross-sectional view of an air actuator.
FIG. 3 is a block diagram schematically showing a configuration example of a control device of the air actuator.
FIG. 4 is a plan view schematically showing the stage apparatus to which an electromagnetic actuator is applied.
FIG. 5 is a schematic functional block diagram of a data processing device.
FIG. 6 shows a collection example of position-dependent data representing stopping stability.
FIG. 7 is a schematic functional block diagram of the data processing device.
FIG. 8 shows an example of distribution data displayed in a three-dimensional space.

### Description of Embodiments

Hereinafter, a form for embodying the present disclosure (hereinafter, also referred to as an embodiment) will be described in detail with reference to the accompanying drawings. In the description and/or the drawings, the same reference signs are assigned to the same or equivalent components, members, processes, and the like, and repeated descriptions thereof are omitted. The scale and shape of each unit shown in the drawings are set for convenience to simplify the description, and are not to be construed as limiting unless otherwise specified. The embodiment is merely an example and does not limit the scope of the present disclosure in any way. All the features and combinations thereof presented in the embodiment are not necessarily essential to the present disclosure. For convenience, the embodiment is presented by decomposing the embodiment into components for each function and/or for each function group implementing the embodiment. However, one component in the embodiment may actually be implemented by a combination of a plurality of separate components, and a plurality of components in the embodiment may actually be implemented by a single integrated component.

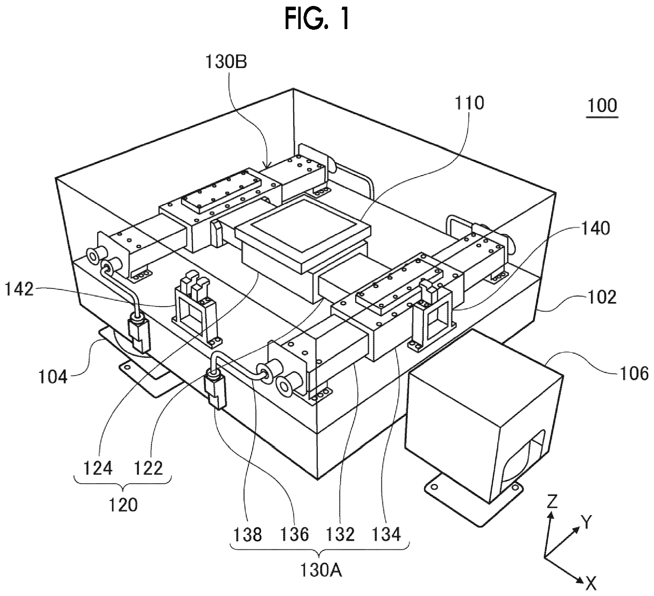

FIG. 1 is a perspective view of a stage apparatus 100 to which a fluid actuator as a first embodiment of a drive device according to the present disclosure is applied. In the present embodiment, an air actuator that drives a stage 110 as a driven object with air as a working fluid is exemplified as the fluid actuator. The stage apparatus 100 includes a base plate 102, a vibration isolation table 104, a vibration isolation device 106, the stage 110, one X-axis air actuator 120, and two Y-axis air actuators 130A and 130B (hereinafter, collectively referred to as a Y-axis air actuator 130). The base plate 102 is supported by the vibration isolation table 104. The stage apparatus 100 is formed in an H-shape in a top view by the X-axis air actuator 120 as an upper shaft and the two Y-axis air actuators 130A and 130B as lower shafts. The vibration isolation device 106 suppresses the propagation of vibration from the floor or the like on which the stage apparatus 100 is disposed to the base plate 102.

The X-axis air actuator 120 and the Y-axis air actuator 130 are fluid actuators that drive the stage 110 as a driven object along the X-axis and the Y-axis by using air as a working fluid. An object to be processed (not shown), such as a semiconductor wafer, is placed on the stage 110. The X-axis air actuator 120 includes a guide 122 (square shaft), a slider 124, a servo valve 126 (not shown), and a pipe 128 (not shown). Similarly, the Y-axis air actuator 130 includes a guide 132, a slider 134, a servo valve 136, and a pipe 138. The stage 110 is provided on the slider 124. Both ends of the guide 122 are supported by the slider 134 of the Y-axis air actuator 130.

The sliders 124 and 134 constitute a drive unit that drives the stage 110 as a driven object along the X-axis and the Y-axis. In addition, the servo valves 126 and 136 constitute a working fluid supply unit that supplies air to the sliders 124 and 134 based on the intake and exhaust amount (manipulated variable which is an output of a control device) which is the working amount of air calculated by a control device (not shown). The pipes 128 and 138 circulate air between the drive unit and the working fluid supply unit. The position sensor 140 detects the position of the stage 110 in the X-axis direction, and the position sensor 142 detects the position of the stage 110 in the Y-axis direction.

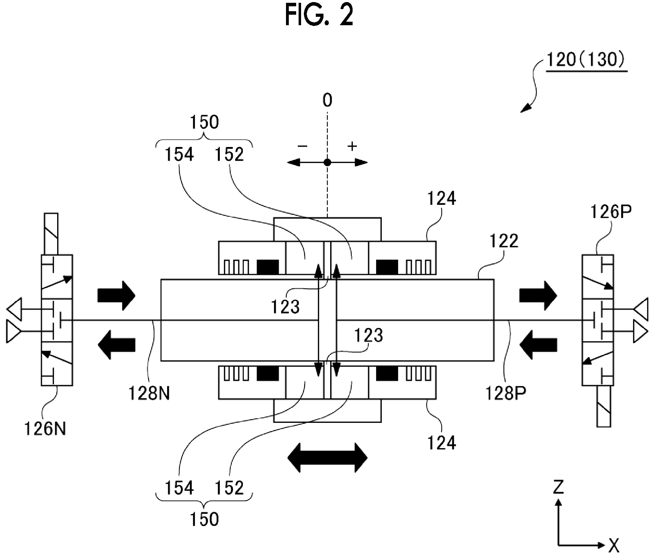

FIG. 2 is a schematic cross-sectional view of the air actuator. The X-axis air actuator 120 includes the guide 122, the slider 124, the servo valve 126 (spool valve), and the pipe 128. Pressurized air is supplied between an outer peripheral surface of the guide 122 and an inner peripheral surface of the slider 124 to form a hydrostatic bearing. The slider 124 floating from the guide 122 by the pressurized air is smoothly movable in the X-axis direction in a non-contact manner with the guide 122. The slider 124 is provided with a servo chamber 150 that is an internal space. The servo chamber 150 is partitioned into a positive-side chamber 152 and a negative-side chamber 154 by a pressure-receiving plate 123 integrally formed with the guide 122.

The slider 124 is driven by the servo valve 126. The servo valve 126 controls the intake and exhaust amount of a control port depending on the position of a spool. The air actuators 120 and 130 of each axis include a pair of servo valves 126P and 126N disposed on the positive side and the negative side. The control port of the servo valve 126P on the positive side communicates with the positive-side chamber 152 via a positive-side pipe 128P. The control port of the servo valve 126N on the negative side communicates with the negative-side chamber 154 via a negative-side pipe 128N. The position of the slider 124 with respect to the guide 122 (pressure-receiving plate 123) is controlled by a differential pressure generated between the positive-side chamber 152 and the negative-side chamber 154 depending on the spool positions of the servo valves 126P and 126N. Although the X-axis air actuator 120 has been mainly described above, the Y-axis air actuator 130 may also be configured in the same manner as the X-axis air actuator 120.

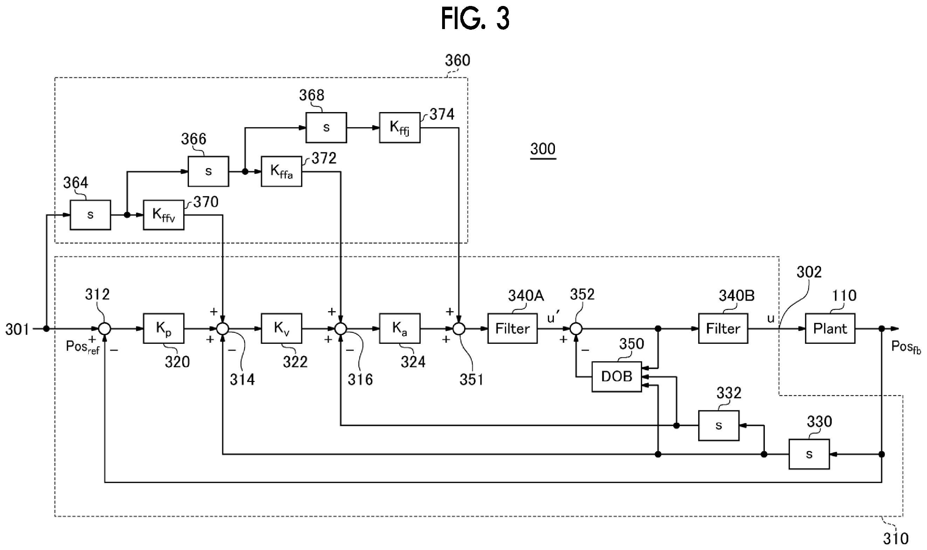

FIG. 3 is a block diagram schematically showing a configuration example of a control device 300 of the air actuators 120 and 130. The control device 300 is responsible for driving control of the stage 110 as a driven object in the air actuators 120 and 130. The control device 300 controls any manipulated variable for the air actuators 120 and 130 in order to control any controlled variable of the stage 110. The combination of the controlled variable of the stage 110 and the manipulated variable for the air actuators 120 and 130 is optional as long as the driving control of the stage 110 by the control device 300 and/or the air actuators 120 and 130 can be realized. In the example in the present embodiment, the position of the stage 110 is used as the controlled variable, and the intake and exhaust amount u for the servo valves 126 and 136 is used as the manipulated variable.

Since the piping resonance and other mechanical resonances cannot be ignored, the air actuators 120 and 130 and/or the stage 110 as the control targets of the control device 300 have a high degree of the control model of 3 or more, and are strictly at least a fifth-order control system. However, it is difficult to realize the fifth-order control system in the actual control device 300 due to the trade-off between the increase in order by the high-order differential element and the deterioration in control responsiveness, and most of the control devices 300 that are practically used remain in the third-order control system as shown in FIG. 3.

The at least third-order control device 300 includes a feedback (FB) control unit 310 that performs FB control based on a plurality of (preferably, at least three) FB gains, and a feedforward (FF) control unit 360 that performs FF control based on a plurality of (preferably, at least three) FF gains. Although the details will be described later, the manipulated variable u for the air actuators 120 and 130 as the output of the control device 300 is calculated based on the outputs of both the FF control unit 360 and the FB control unit 310. The manipulated variable u output from the output unit 302 of the control device 300 is a valve command for determining the intake and exhaust amount of the servo valves 126 and 136, and the position (controlled variable) of the stage 110 is controlled by the differential pressure generated by the valve command. The position Pos_{fb} (difference measurement value of the controlled variable) of the stage 110 detected by the position sensors 140 and 142 is used for the FB control in the FB control unit 310.

The FF control unit 360 includes three pairs of differentiators 364, 366, and 368 and proportional compensators 370, 372, and 374 from the input unit 301 to the output unit 302 of the control device 300. The first-stage differentiator 364 differentiates the position command Pos_{ref} as the target value of the controlled variable (position of the stage 110) input to the input unit 301 to convert the position command Pos_{ref} into the speed. The first-stage proportional compensator 370 multiplies the speed by the proportional gain K_{ffv} and calculates the speed command of the stage 110 in combination with the position compensation amount (described later) calculated by the FB control unit 310. The second-stage differentiator 366 differentiates the speed from the differentiator 364 to convert the speed into the acceleration. The second-stage proportional compensator 372 multiplies the acceleration by the proportional gain K_{ffa} and calculates the acceleration command of the stage 110 in combination with the speed compensation amount (described later) calculated by the FB control unit 310. The third-stage differentiator 368 differentiates the acceleration from the differentiator 366. The third-stage proportional compensator 374 multiplies the acceleration by the proportional gain K_{ffj} and calculates the provisional manipulated variable u' in combination with the acceleration compensation amount (described later) calculated by the FB control unit 310.

As described above, the FF control unit 360 includes a plurality of (preferably at least three) FF gains K_{ffv}, K_{ffa}, and K_{ffj} that are sequentially multiplied by the target value Pos_{ref} of the controlled variable (position of the stage 110) of the air actuators 120 and 130. Specifically, three FF gains, that is, the first FF gain K_{ffv} multiplied by the first-order differentiation of the target value Pos_{ref}, the second FF gain K_{ffa} multiplied by the second-order differentiation of the target value Pos_{ref}, and the third FF gain K_{ffj} multiplied by the third-order differentiation of the target value Pos_{ref}, are provided in the FF control unit 360.

The FB control unit 310 is configured as a proportional-differential-second derivative (PDD²) compensator. Specifically, the FB control unit 310 controls the position (controlled variable) of the stage 110 in the major loop or the outer loop and controls the speed and the acceleration of the stage 110 in the minor loop or the inner loop. In the two minor loops, the speed loop on the outer side is also referred to as a mid-loop, and the acceleration loop on the inner side is also simply referred to as an inner loop. The measured speed of the stage 110 is obtained by differentiating the measured position Pos_{fb} as the measured value of the controlled variable of the stage 110 with the differentiator 330, and the measured acceleration of the stage 110 is obtained by further differentiating the measured speed with the differentiator 332.

The FB control unit 310 includes four subtractors 312, 314, 316, and 352 in series from the input unit 301 toward the output unit 302 of the control device 300. The subtractor 312 is a position deviation calculation unit that calculates a position deviation, which is a difference between the position command Pos_{ref} as the target value of the controlled variable (position of the stage 110) input to the input unit 301 of the control device 300 and the measured position Pos_{fb} of the stage 110 as the measured value of the controlled variable. The subtractor 314 is a speed deviation calculation unit that calculates a speed deviation, which is a difference between the speed command obtained based on the calculation described later and the measured speed of the stage 110 output by the differentiator 330. The subtractor 316 is an acceleration deviation calculation unit that calculates an acceleration deviation, which is a difference between the acceleration command obtained based on the calculation described later and the measured acceleration of the stage 110 output by the differentiator 332. The subtractor 352 is a disturbance removal unit that removes a disturbance from a provisional manipulated variable u' obtained based on the calculation described later.

A position proportional compensator 320 is provided as a position compensation element that compensates for the position of the stage 110 between the subtractor 312 that calculates the position deviation and the subtractor 314 that calculates the speed deviation. The position proportional compensator 320 constitutes a speed command calculation unit that calculates the speed command of the stage 110 by multiplying the position deviation by a proportional gain Kₚ and combining the result with the input from the proportional compensator 370 of the FF control unit 360.

A speed proportional compensator 322 is provided as a speed compensation element that compensates for the speed of the stage 110 between the subtractor 314 that calculates the speed deviation and the subtractor 316 that calculates the acceleration deviation. The speed proportional compensator 322 constitutes an acceleration command calculation unit that calculates the acceleration command of the stage 110 by multiplying the speed deviation by a proportional gain Kᵥ and combining the result with the input from the proportional compensator 372 of the FF control unit 360.

An acceleration proportional compensator 324 is provided as an acceleration compensation element that compensates for the acceleration of the stage 110 between the subtractor 316 that calculates the acceleration deviation and the subtractor 352 that removes the disturbance. The acceleration proportional compensator 324 constitutes a provisional calculation unit that obtains the provisional manipulated variable u' by multiplying the acceleration deviation by a proportional gain Kₐ and combining the result with the input from the proportional compensator 374 of the FF control unit 360 (adder 351).

As described above, the FB control unit 310 includes a plurality of (preferably, at least three) FB gains Kₚ, Kᵥ, and Kₐ that are sequentially multiplied by the deviation between the measured value Pos_{fb} and the target value Pos_{ref} of the controlled variable (position of the stage 110) of the air actuators 120 and 130. Specifically, three FB gains, that is, a first FB gain Kₚ that is multiplied by the position deviation based on the measured value Pos_{fb} (measured position), a second FB gain Kᵥ that is multiplied by the speed deviation based on the first-order differentiation of the measured value Pos_{fb} (measured speed), and a third FB gain Kₐ that is multiplied by the acceleration deviation based on the second-order differentiation of the measured value Pos_{fb} (measured acceleration), are provided in the FB control unit 310.

In addition to the above-described configuration, the FB control unit 310 includes a notch filter 340 and a disturbance observer 350.

The notch filter 340 is a band-stop filter having a narrow stop band centered on a notch frequency ωₙₒ, and is configured by two filter elements 340A and 340B provided in front and rear of the subtractor 352. For example, the notch frequency ωₙₒ is set to a value close to the frequency ω₀ of the piping resonance for the purpose of removing the piping resonance. In the example of FIG. 3, the provisional manipulated variable u' is obtained by inputting the output of the adder 351 that adds the FF control output from the proportional compensator 374 of the FF control unit 360 and the FB control output from the acceleration proportional compensator 324 of the FB control unit 310 to the first filter element 340A.

The disturbance observer (DOB) 350 as a disturbance estimator is a state observer that estimates the disturbance with respect to the position (controlled variable) of the stage 110 based on the provisional manipulated variable u' and the measured speed and the measured acceleration of the stage 110. The measured value supplied to the disturbance observer 350 is not limited to the speed and the acceleration of the stage 110, and may be any combination of the drive variable of the stage 110 including the position. The subtractor 352 removes (subtracts) the disturbance estimated by the disturbance observer 350 from the provisional manipulated variable u' from the first filter element 340A. The output of the subtractor 352 (provisional manipulated variable u' from which the disturbance is removed) is input to the second filter element 340B, and the manipulated variable u, which is the final output of the control device 300, is obtained in the output unit 302.

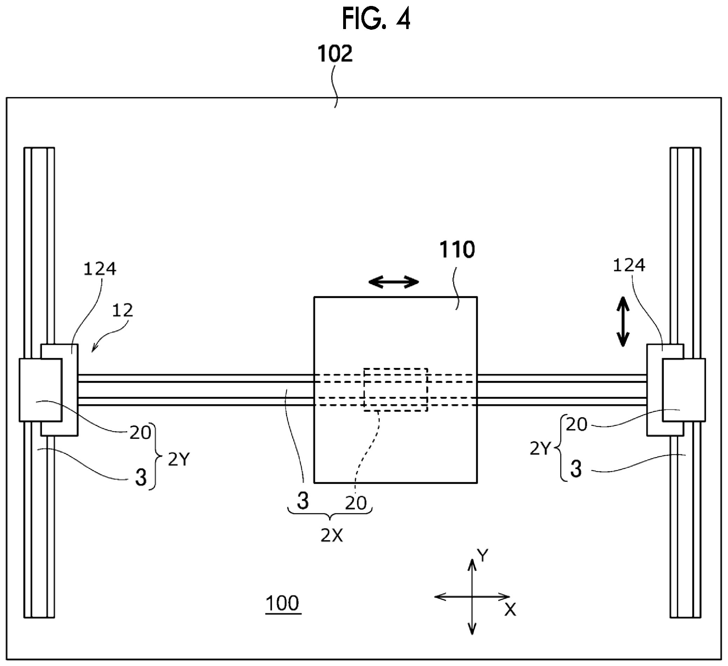

FIG. 4 is a plan view schematically showing a stage apparatus 100 to which an electromagnetic actuator as a second embodiment of the drive device according to the present disclosure is applied. The stage apparatus 100 is an XY stage that positions a table or a stage as a driven object on which an object to be processed such as a semiconductor wafer is placed in an X-axis direction (left-right direction in FIG. 4) and a Y-axis direction (up-down direction in FIG. 4). The stage apparatus 100 includes a pair of Y-stages 12 that extend in the Y-axis direction and drive the table in the Y-axis direction, an X-stage 110 that is integrated with the table, extends in the X-axis direction, and drives the table in the X-axis direction, and the base plate 102. The pair of Y-stages 12 are connected to both ends in the X-axis direction of the X-stage 110 through sliders 124. The Y-stages 12 and the X-stage 110 form an H shape in a top view.

In the configuration of the stage apparatus 100, at least the table, the Y-stages 12, and the X-stage 110 may be accommodated in a vacuum chamber of which the inside is kept in a vacuum state. In the present specification, the term "vacuum" refers to a state of a space filled with gas at a pressure lower than normal atmospheric pressure. The vacuum is classified into a low vacuum (100 kPa to 100 Pa), a medium vacuum (100 Pa to 0.1 Pa), a high vacuum (0.1 Pa to 10⁻⁵ Pa), an ultra-high vacuum (10⁻⁵ Pa to 10⁻⁸ Pa), an extremely high vacuum (10⁻⁸ Pa or less), and the like depending on the pressure region. The stage apparatus 100 according to the present embodiment may be used in a vacuum environment of any of the above classifications. In addition, the stage apparatus 100 according to the present embodiment may be used in a non-vacuum environment that does not correspond to any of the above classifications.

A linear motor 2X and a linear motor 2Y as electromagnetic actuators are provided in the X-stage 110 and the Y-stage 12, respectively. The magnetic linear power in the X-axis direction or the Y-axis direction, which is electromagnetically generated by each of the linear motors 2X and 2Y, linearly drives the table as the driven object in the X-axis direction or the Y-axis direction.

The linear motor 2X that is responsible for the linear drive in the X-axis direction includes a stator 3 that constitutes a track in the X-axis direction and a mover 20 that is movable in the X-axis direction along the stator 3. The table as the driven object is fixed to the mover 20 and moves integrally with the mover 20. A pair of linear motors 2Y that are responsible for the linear drive in the Y-axis direction includes a stator 3 that constitutes a track in the Y-axis direction and a mover 20 that is movable in the Y-axis direction along the stator 3. The slider 124 is fixed to the mover 20 and moves integrally with the mover 20.

Here, since the pair of sliders 124 are connected to both ends of the armature 2 of the linear motor 2X, the pair of linear motors 2Y linearly drive the armature 2 of the linear motor 2X along with the pair of sliders 124 in the Y-axis direction. Then, since the table is present on the armature 2 (track) of the linear motor 2X, the pair of linear motors 2Y linearly drive the table in the Y-axis direction.

As shown in FIGS. 1 to 4, for example, the stage apparatus 100 according to the present embodiment, which can realize high-accuracy positioning or driving regardless of whether the environment is a vacuum environment or a non-vacuum environment, is suitable for use in a device manufacturing apparatus such as a semiconductor manufacturing apparatus such as an exposure apparatus, an ion implanter, a heat treatment apparatus, an ashing apparatus, a sputtering apparatus, a dicing apparatus, an inspection apparatus, or a cleaning apparatus, or a flat panel display (FPD) manufacturing apparatus, for positioning or driving a table on which a semiconductor wafer or the like as an object to be processed is placed, as the driven object. The processing device to which the stage apparatus 100 of the present embodiment can be applied may be any apparatus that positions any object to be processed by using the stage apparatus 100 or the positioning device, and may be, for example, any manufacturing apparatus, any processing apparatus (for example, a machine tool), or any inspection apparatus.

In the stage apparatus 100 of FIGS. 1 and 4, the stage 110 as the driven object is driven in the X-axis direction and the Y-axis direction. In other words, the stage 110 is two-dimensionally driven in a two-dimensional XY plane (typically a flat surface, but may be a curved surface). Here, a movable region or a movable surface of the stage 110, which is typically rectangular, is determined by both ends of the movable range of the stage 110 in the X-axis direction and both ends of the movable range of the stage 110 in the Y-axis direction. The movable region of the stage 110 is not limited to the two-dimensional movable surface (XY plane), and may be a three-dimensional movable space (XYZ space). A drive device that drives the stage 110 with the three-dimensional movable space as the movable region is provided with a Z drive mechanism (not shown) that drives the stage 110 in the Z-axis direction orthogonal to the X-axis direction and the Y-axis direction, in addition to the XY drive mechanism described above with reference to FIGS. 1 to 4. As described above, the drive device according to the present embodiment may be any drive device that drives the driven object such as the stage 110 in a movable region of two or more dimensions (that is, a two-dimensional movable surface or a three-dimensional movable space). The data processing device according to the present embodiment is responsible for data processing in such a drive device.

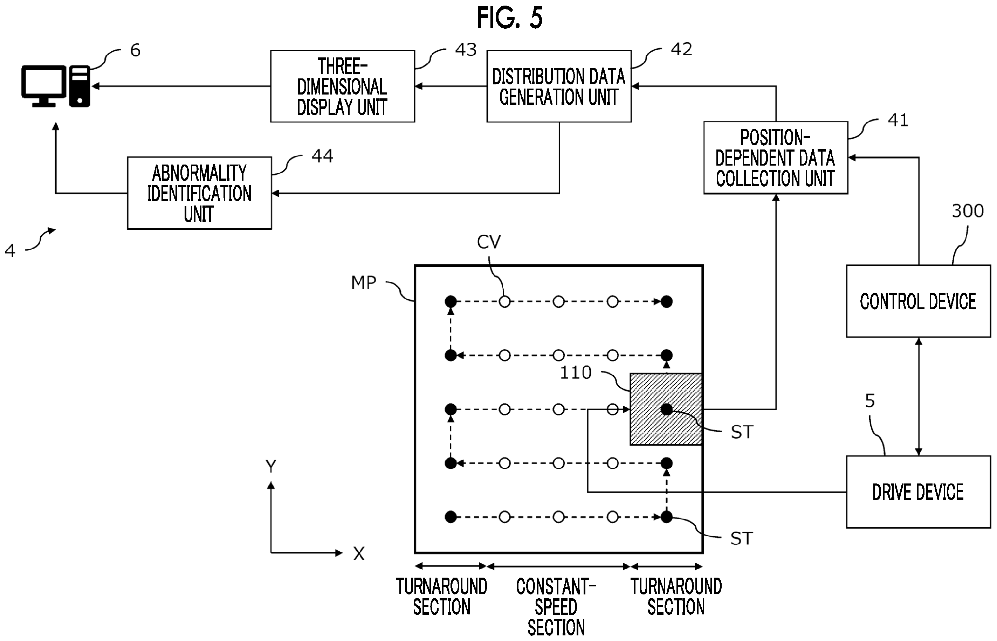

FIG. 5 is a schematic functional block diagram of a data processing device 4 according to the present embodiment. The data processing device 4 includes a position-dependent data collection unit 41, a distribution data generation unit 42, a three-dimensional display unit 43, and an abnormality identification unit 44. Some of these functional blocks may be omitted as long as the data processing device 4 can realize at least some of the actions and/or effects described below. These functional blocks may be implemented by cooperation between hardware resources such as a central processing unit, a memory, an input device, and an output device of a computer and a peripheral device connected to the computer and software executed using the hardware resources. Regardless of the type and installation location of the computer, each of the above-described functional blocks may be realized by the hardware resources of a single computer, or may be realized by combining the hardware resources distributed in a plurality of computers.

In the example of FIG. 5, the stage 110 as the driven object is driven in a two-dimensional movable surface MP in the XY plane by the drive device 5 such as the X-axis air actuator 120 and the Y-axis air actuator 130 (fluid actuator) in FIG. 1 and the linear motors 2X and 2Y (electromagnetic actuator) in FIG. 4 under the control of the control device 300 as shown in FIG. 3. The shape of the movable surface MP is arbitrary, but is, for example, a rectangular shape as shown in the drawing. The driving mode or the drive sequence of the stage 110 in the movable surface MP is also arbitrary, but a scan method and a step-and-repeat method are generally used in the stage apparatus 100.

In the example of FIG. 5, the stage 110 is driven by a scan method (the step-and-repeat method will be described later). Specifically, the stage 110 can scan substantially the entire movable surface MP by alternately performing, for example, an X scan with a long stroke in the X-axis direction (left-right direction in FIG. 5) and, for example, a Y scan with a short stroke in the Y-axis direction (up-down direction in FIG. 5).

Such a scan drive is performed by a processing device (not shown) such as an ion implanter to perform a desired process on all target sites on the semiconductor wafer or the like on the stage 110. Therefore, the stage 110 does not always need to scan the entire movable surface MP, and may scan the entire semiconductor wafer or the like as the object to be processed. In the present embodiment, for convenience, an example in which the stage 110 scans the entire movable surface MP will be described. The description of the example in which the entire processing target surface of the object to be processed such as a semiconductor wafer is scanned will be made by replacing the "movable surface MP" in the following description with the "processing target surface of the object to be processed." In a case where the object to be processed is a semiconductor wafer, the processing target surface thereof is typically circular rather than rectangular as in the movable surface MP in FIG. 5.

In the example of FIG. 5, the stage 110 is driven to scan with a lower left corner of the movable surface MP as a scan start position and an upper right corner of the movable surface MP as a scan end position. In each X scan, the stage 110 is driven in the X-axis direction by the drive device 5 (the X-axis air actuator 120 in FIG. 1, the linear motor 2X in FIG. 4, or the like) with a long stroke over substantially the entire length of the movable surface MP in the X-axis direction. Here, both end portions (left end portion and right end portion in FIG. 5) of the long stroke in the X-axis direction are acceleration/deceleration sections (may be referred to as a turnaround section as will be described later) in which the stage 110 is accelerated or decelerated. Then, an intermediate section between the acceleration/deceleration sections at both end portions is typically a constant-speed section in which the stage 110 is driven in the X-axis direction at a constant speed.

In each Y scan following each X scan, the stage 110 is driven in the Y-axis direction by the drive device 5 (the Y-axis air actuator 130 in FIG. 1, the linear motor 2Y in FIG. 4, or the like) with a short stroke significantly shorter than the entire length of the movable surface MP in the Y-axis direction. Following this Y scan, an X scan in a direction opposite to the immediately preceding X scan is performed. Therefore, both end portions of the movable surface MP in the X-axis direction, in which the Y scan is performed, are the turnaround sections in which the stage 110 is turned back in the X-axis direction.

The position-dependent data collection unit 41 collects position-dependent data related to the stage 110 for a plurality of positions of the stage 110 (in the example of the present embodiment, a plurality of two-dimensional positions or XY positions) in the movable surface MP as the movable region. Here, the position-dependent data is any data related to the stage 110 that can be acquired from the stage 110 itself as the driven object, the drive device 5 as the drive entity, the control device 300 as the control entity, or the like when the stage 110 is at each position in the movable surface MP.

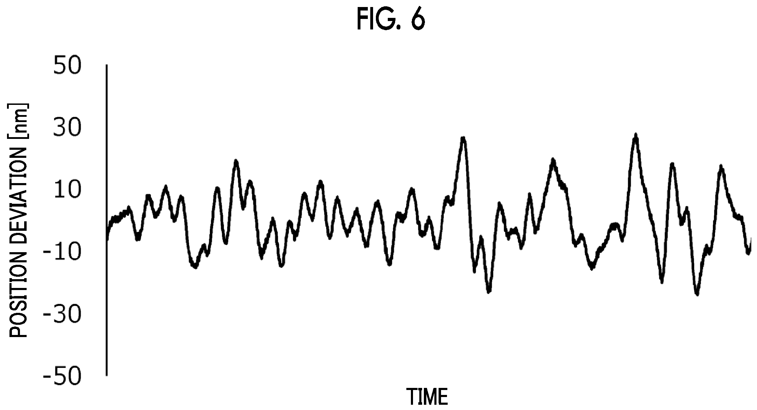

The position-dependent data may be data based on any physical quantity related to the state or motion of the stage 110 at each position in the movable surface MP. For example, in the turnaround section in FIG. 5, a position deviation (output of the subtractor 312 in FIG. 3) between an actual stop position and a target stop position ST or a temporal change or variation thereof when the stage 110 stops at each target stop position ST schematically indicated by a black circle may be collected as the position-dependent data by the position-dependent data collection unit 41. For example, as schematically shown in FIG. 6, a variation (standard deviation or the like) of the position deviation over a predetermined time when the stage 110 stops at the target stop position ST is collected as the position-dependent data representing the stopping stability at the target stop position ST by the position-dependent data collection unit 41.

In addition, in the constant-speed section in FIG. 5, a position deviation (output of the subtractor 312 in FIG. 3), a speed deviation (output of the subtractor 314 in FIG. 3), an acceleration deviation (output of the subtractor 316 in FIG. 3), a temporal change or variation thereof, or the like when the stage 110 passes through each periodic constant-speed passing position CV schematically indicated by a white circle may be collected as the position-dependent data by the position-dependent data collection unit 41. Further, the position-dependent data collection unit 41 may collect an output (estimated disturbance) of the disturbance observer 350 in FIG. 3 or a temporal change or variation thereof as the position-dependent data for the stage 110 at each position (any position not limited to the target stop position ST or the constant-speed passing position CV) in the movable surface MP.

In addition, the position-dependent data collection unit 41 may collect various command values such as a manipulated variable, a position command, a speed command, an acceleration command, and a command for a driving force of the linear motors 2X and 2Y or a torque in a case of a rotary motor in the stage apparatus 100 in FIG. 4 in the control device 300 in FIG. 3, or a temporal change or variation thereof as the position-dependent data for the stage 110 at each position (any position not limited to the target stop position ST or the constant-speed passing position CV) in the movable surface MP.

The position-dependent data collection unit 41 can collect various position-dependent data as described above during a processing period in which a processing device (not shown) such as an ion implanter performs processing on an object to be processed such as a semiconductor wafer. However, in the scan drive as described above, since the stop position ST (black circle) is present only in the turnaround section, there is a possibility that data of the position deviation indicating the stability when the stage 110 is stopped is collected in abundance in the turnaround section, while the data is hardly collected in the constant-speed section. In this way, in a case where the collection amount of the position-dependent data during the processing period by the processing device varies greatly at each position in the movable surface MP, the position-dependent data collection unit 41 may move the stage 110 to a position where the collection amount of the position-dependent data is small during a non-processing period in which the processing device does not perform processing on the object to be processed, and collect the position-dependent data.

For example, the position-dependent data collection unit 41 may stop the stage 110 at a position (for example, the constant-speed passing position CV) where the stage 110 is not stopped during the processing period, and collect position-dependent data such as a position deviation when the stage 110 is stopped at the position during the non-processing period in which the processing device does not perform processing on the object to be processed. In this way, by driving the stage 110 to any position in the movable surface MP during the non-processing period as necessary, the same type of position-dependent data (for example, the position deviation when stopped) can be collected substantially over the entire movable surface MP. In a case where the same type of position-dependent data is collected a plurality of times for the same position in the movable surface MP, a statistical value such as an average value thereof may be used as the position-dependent data representing the position.

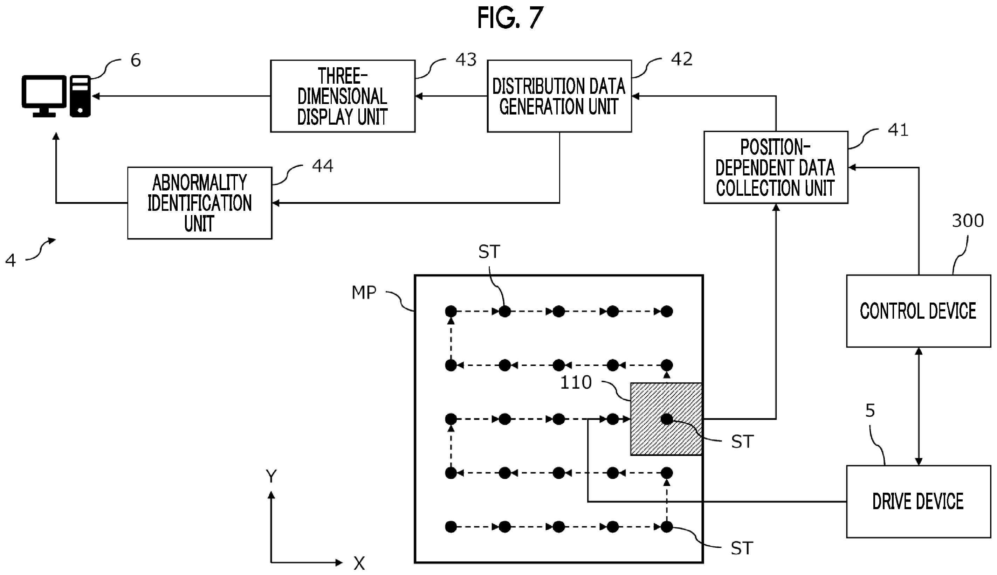

On the other hand, in the drive in the step-and-repeat method shown in FIG. 7, the movement and stop of the stage 110 are repeated in small increments with respect to the drive in the scan method shown in FIG. 5. Therefore, in FIG. 5, the stage 110 is stopped even in the constant-speed section where the stage 110 is not stopped. In such a step-and-repeat drive, the stage 110 can be temporarily stopped substantially over the entire movable surface MP or the entire processing target surface of the object to be processed such as a semiconductor wafer.

As schematically shown by a black circle in FIG. 7, the stop position ST is substantially uniformly distributed over the entire movable surface MP. The position-dependent data collection unit 41 may collect position-dependent data such as a position deviation when stopped for each of these stop positions ST. In addition, the position-dependent data collection unit 41 may collect, as position-dependent data, a position deviation, a speed deviation, an acceleration deviation, a disturbance estimated by the disturbance observer 350 in FIG. 3, or a temporal change or variation thereof during each drive of the stage 110 between consecutive stop positions ST.

As described above, in the step-and-repeat method, the position-dependent data collection unit 41 can collect various types of position-dependent data substantially over the entire movable surface MP or the entire processing target surface of the object to be processed during a processing period in which a processing device (not shown) such as an inspection apparatus performs processing on the object to be processed such as a semiconductor wafer. In the scan method of FIG. 5, the drive of the stage 110 and the collection of the position-dependent data are performed during the non-processing period as necessary, but in the step-and-repeat method of FIG. 7, it is sufficient to perform the drive of the stage 110 and the collection of the position-dependent data during the processing period in principle.

It is preferable that the collection of the position-dependent data in the movable surface MP by the position-dependent data collection unit 41 as described above is performed over a plurality of processing periods and/or a plurality of non-processing periods for a plurality of (preferably, a large number of) objects to be processed. In this case, as described above, it is preferable that the same type of position-dependent data collected over a large number of objects to be processed for the same position in the movable surface MP is subjected to statistical processing such as average processing and is used as the position-dependent data representing the position. The position-dependent data may be affected not only by the state of each position on the movable surface MP of the drive device 5 that is originally desired to be grasped but also by the weight and disposition of the object to be processed, but the influence of a specific object to be processed can be removed through the statistical processing as described above.

The distribution data generation unit 42 generates distribution data of various types of position-dependent data collected by the position-dependent data collection unit 41 over at least a part of a movable region. In the example of the present embodiment in which the movable region is the two-dimensional movable surface MP, the distribution data generation unit 42 generates the distribution data of the position-dependent data over at least a part of a two-dimensional region in the movable surface MP, in a three-dimensional space. Specifically, each position-dependent data D at each XY position or each XY coordinate (X, Y) in the movable surface MP constitutes the distribution data. In other words, the distribution data is composed of a set of three-dimensional data of (X, Y, D) in a three-dimensional space formed by the X-axis, the Y-axis, and the D-axis (where various types of position-dependent data D are uniquely determined according to the XY coordinates (X, Y)). Here, since the position-dependent data D is not present at the XY coordinates (X, Y) at which the position-dependent data collection unit 41 does not collect the position-dependent data D, the distribution data generation unit 42 or the position-dependent data collection unit 41 may calculate or estimate the position-dependent data D for the XY coordinates (X, Y) by interpolation or the like based on a plurality of position-dependent data collected in the vicinity of the XY coordinates (X, Y).

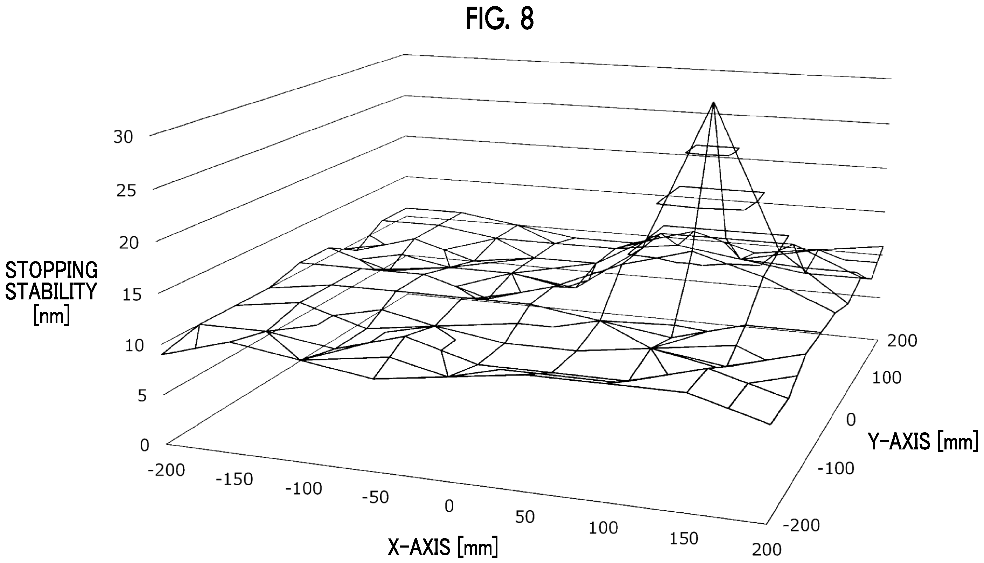

The three-dimensional display unit 43 displays the distribution data generated by the distribution data generation unit 42 in the three-dimensional space. For example, the three-dimensional display unit 43 displays the distribution data as schematically shown in FIG. 8 as an example in the three-dimensional space on a display (display device) of the computer 6 used by a user such as an administrator of the stage apparatus 100. In the example of FIG. 8, the distribution of the stopping stability as the position-dependent data D is visualized in a contour line shape for each position in the XY plane formed by the X-axis and the Y-axis.

A user who visually recognizes the screen as shown in FIG. 8 can intuitively identify an abnormal portion in which the position-dependent data such as the stopping stability is significantly changed or deteriorated on the movable surface MP of the stage 110. In addition, the user can grasp the type, the cause, the severity, and the like of the abnormality based on various features visualized such as the shape, the size, and the degree of change in the position-dependent data compared to the normal portion of the abnormal portion. For example, in a case where the abnormal portion is distributed in a point shape or a mountain shape in the vicinity of a specific XY position as shown in FIG. 8, it is suspected that a foreign matter such as dust that hinders the driving of the stage 110 is present at the XY position. In addition, in a case where the abnormal portion is distributed over a specific X-axis range, it is suspected that an abnormality such as a scratch or damage is present in a mechanism that is responsible for the driving in the X-axis direction in the X-axis range in the drive device 5.

The type of the abnormality may include a maladjustment of the mechanical adjustment (for example, distortion during installation or excessive tightening of screws) or a decrease in assembly accuracy based on the maladjustment. In addition, the type of the abnormality may include an undesirable state change of the device (for example, adhesion of foreign matter, friction due to deterioration, insufficient lubricant such as grease, mechanical misalignment, and influence of disturbance from another device).

In addition to or instead of the three-dimensional display for the user through the three-dimensional display unit 43 as described above, the abnormality identification unit 44 may automatically identify the abnormality as described above related to a specific position in the movable region based on the distribution data generated by the distribution data generation unit 42. Further, the abnormality identification unit 44 may additionally display information related to the identified abnormality on the screen as shown in FIG. 8 displayed by the three-dimensional display unit 43. In addition, the abnormality identification unit 44 may notify the user of the fact that the abnormality is identified in a mode (for example, sound or light) different from the screen display by the three-dimensional display unit 43.

The three-dimensional display unit 43 may display the temporal change as a video or an animation in addition to or instead of the static screen as shown in FIG. 8. By enabling the user to visually grasp such a temporal change, the user can intuitively understand the occurrence pattern or the degree of progression (or the severity) of the abnormality. The abnormality identification unit 44 may be configured with artificial intelligence that has been subjected to machine learning using a large amount of training data, which is a set of the distribution data as shown in FIG. 8 and information related to the abnormality present in the distribution data, to be able to identify the abnormality with the same accuracy as the user or with higher accuracy than the user.

Various abnormalities or deterioration of the device identified or estimated through the position-dependent data as described above may be notified or informed to a related user such as an operator of the device in various modes. For example, the related user may be automatically notified of the fact that the abnormality or the deterioration is identified or estimated through the position-dependent data, or detailed information such as the type, the cause, the severity, and the countermeasure method of the abnormality or the deterioration by e-mail or the like. In addition, the abnormality identification unit 44 may notify the related user of the recommended timing, frequency, content, and the like of the maintenance of the device based on the type, the cause, the severity, and the like of the identified or estimated abnormality or deterioration.

In the above example, the movable region of the stage 110 is the two-dimensional movable surface MP (XY plane), but the movable region of the stage 110 may be a three-dimensional movable space (XYZ plane). In this case, the position-dependent data collection unit 41 collects various types of position-dependent data D for the three-dimensional XYZ coordinates (X, Y, Z). Therefore, the distribution data generated by the distribution data generation unit 42 is configured with a set of four-dimensional data of (X, Y, Z, D). Since the three-dimensional display unit 43 cannot display the entire four-dimensional distribution data on one screen, the three-dimensional display unit 43 may perform the three-dimensional display as shown in FIG. 8 for a specific Z coordinate designated by the user, for example.

The present disclosure has been described above based on the embodiment. Various modification examples are possible for combinations of the components and processes in the embodiments described as examples, and it will be apparent to those skilled in the art that such modification examples are included within the scope of the present disclosure.

A configuration, an action, and a function of each device or each method described in the embodiment can be implemented by hardware resources or software resources or by cooperation between hardware resources and software resources. As hardware resources, for example, a processor, ROM, RAM, and various integrated circuits can be used. As software resources, for example, programs such as an operating system and an application can be used.

### Industrial Applicability

The present disclosure relates to a data processing device and the like in a drive device.

### Reference Signs List

- 4: data processing device
- 5: drive device
- 6: computer
- 41: position-dependent data collection unit
- 42: distribution data generation unit
- 43: three-dimensional display unit
- 44: abnormality identification unit
- 100: stage apparatus
- 110: stage
- 300: control device

## Claims

1. A data processing device comprising:
in a drive device that drives a driven object in a movable region of two or more dimensions,
a position-dependent data collection unit that collects position-dependent data related to the driven object at a plurality of positions of the driven object in the movable region; and
a distribution data generation unit that generates distribution data of the position-dependent data over at least a part of the movable region.

2. The data processing device according to claim 1,
wherein the position-dependent data collection unit collects the position-dependent data when the driven object stops at the plurality of positions in the movable region.

3. The data processing device according to claim 2,
wherein the position-dependent data is based on a position deviation, when the driven object stops at a plurality of target positions in the movable region, between an actual stop position and the target position.

4. The data processing device according to claim 2,
wherein the driven object is a stage on which an object to be processed, which is subjected to predetermined processing by a processing device, is placed, and
the position-dependent data collection unit collects the position-dependent data at the plurality of positions at which the stage stops during a processing period in which the processing device performs the processing on the object to be processed.

5. The data processing device according to claim 4,
wherein, during a non-processing period in which the processing device does not perform the processing on the object to be processed, the position-dependent data collection unit stops the stage at a position at which the stage does not stop during the processing period and collects the position-dependent data at the position.

6. The data processing device according to any one of claims 1 to 5
wherein the movable region is a two-dimensional movable surface,
the position-dependent data collection unit collects the position-dependent data at a plurality of two-dimensional positions of the driven object in the movable surface, and
the distribution data generation unit generates the distribution data of the position-dependent data over at least a part of a two-dimensional region in the movable surface, in a three-dimensional space.

7. The data processing device according to claim 6, further comprising:
a three-dimensional display unit that displays the distribution data in the three-dimensional space.

8. The data processing device according to any one of claims 1 to 5, further comprising:
an abnormality identification unit that identifies an abnormality related to a specific position in the movable region based on the distribution data.

9. The data processing device according to claim 8,
wherein the abnormality identification unit is configured with artificial intelligence that has been subjected to machine learning using training data, which is a set of the distribution data and information related to an abnormality present in the drive device at the time of generation of the distribution data.

10. The data processing device according to any one of claims 1 to 5,
wherein the drive device is a fluid actuator that drives the driven object in the movable region with a working fluid.

11. The data processing device according to any one of claims 1 to 5,
wherein the drive device is an electromagnetic actuator that electromagnetically drives the driven object in the movable region.

12. A data processing method comprising:
in a drive device that drives a driven object in a movable region of two or more dimensions,
collecting position-dependent data related to the driven object at a plurality of positions of the driven object in the movable region; and
generating distribution data of the position-dependent data over at least a part of the movable region.

13. A storage medium storing a data processing program causing a computer to execute:
in a drive device that drives a driven object in a movable region of two or more dimensions,
collecting position-dependent data related to the driven object at a plurality of positions of the driven object in the movable region; and
generating distribution data of the position-dependent data over at least a part of the movable region.
